# EUROPÄISCHE PATENTANMELDUNG

(11) **EP 0 951 120 A1**
(43) Veröffentlichungstag der Anmeldung: **20.10.1999**
(21) Anmeldenummer: 99104536.0
(22) Anmeldetag: 06.03.1999
(51) Int. Cl.: H02B 1/46

(54) **Rechteckiges Gehäuse zur Aufnahme von elektrischen oder elektronischen Bauteilen**

(30) Priorität: 17.04.1998 DE 29806873 U
(71) Anmelder: H.-J. Bernstein GmbH, 32479 Hille (DE)
(72) Erfinder: Weiss, Jürgen, 32312 Lübbecke (DE)
(74) Vertreter: Stracke, Alexander, Dipl.-Ing.

(57) **Zusammenfassung**

Gegenstand der Erfindung ist ein rechteckiges Gehäuse (1) zur Aufnahme von elektrischen oder elektronischen Bauteilen, umfassend eine Rückwand (2), eine vorzugsweise als anscharnierte Tür (3) ausgebildete Vorderwand, sowie eine aus vier Seitenwänden bestehenden Rahmen (4), wobei zumindest der Rahmen (4) aus Blech hergestellt ist. Die Besonderheit des Gehäuses (1) liegt darin, daß die den Rahmen (4) bildenden Seitenwände aus an ihren der Vorderwand (3) und der Rückwand (2) zugewandten Längskanten mehrfach abgewinkelten und im Querschnitt C-förmig gestalteten Profilen bestehen, wobei die Abkantungen auf beiden Seiten des Rahmens (4) gleich ausgeführt und derart gestaltet sind, daß auf jeder Seite des Rahmens (4) zwei Nuten gebildet sind, wobei eine der Nuten im späteren Gehäuseinneren und die jeweils andere Nut im von außen zugänglichen Bereich des Gehäuses (1) liegt.

Ein derartiges Gehäuse (1) ist einerseits weitgehend verschnittfrei herstellbar und die durch die mehrfachen Abkantungen gebildeten innen- sowie außenliegenden Nuten bieten ideale Befestigungsmöglichkeiten sowohl für im Gehäuseinneren zu montierende Bauteile wie auch für die Festlegung von Rückwand (2) und Vorderwand (3).

## Beschreibung

Die vorliegende Erfindung betrifft ein rechteckiges Gehäuse zur Aufnahme von elektrischen oder elektronischen Bauteilen, umfassend eine Rückwand und eine vorzugsweise als anscharnierte Tür ausgebildete Vorderwand, sowie einen aus vier Seitenwänden bestehenden Rahmen, mit dem die Rückwand und die Vorderwand verbunden sind, wobei zumindest der Rahmen aus Blech hergestellt ist.

Rechteckige Gehäuse zur Aufnahme von elektrischen oder elektronischen Bauteilen sind in vielerlei Ausführungsformen bekannt.

Derartige Gehäuse werden sowohl aus Kunststoff wie auch aus Metall hergestellt. Bei den aus Metall hergestellten Gehäusen sind Konstruktionen bekannt, bei denen die Seitenwände aus stranggezogenen Profilen bestehen, die über entsprechende Eckverbinder zu einem stabilen Rahmen zusammengesetzt werden. Die Vorder- und die Rückwand werden dann separat an den vorbereiteten Rahmen montiert.

Unter die Gruppe der aus Metall hergestellten Gehäuse, der hier in Rede stehenden Art fallen auch die aus Blech gefertigten Gehäuse.

Dabei ist es bislang bekannt, aus einem einstückigen Zuschnitt einen Kasten zu bilden, der aus einer Rückwand und den vier Seitenwänden besteht.

Bei diesen Konstruktionen ist als nachteilig anzusehen, daß bei dem einstückigen Zuschnitt in den vier Eckbereichen ein relativ hoher Anteil an Verschnitt entsteht und nachteilig ist weiterhin, daß derartige, aus Blech gefertigte Gehäuse häufig viele Zusatzteile und Nachbearbeitungen erforderlich machen, wenn es darum geht, Befestigungsmöglichkeiten für im Gehäuse unterzubringende elektrische oder elektronische Bauteile zu schaffen.

Der vorliegenden Erfindung liegt die Aufgabe zugrunde, ein Gehäuse der gattungsgemäßen Art zu schaffen, welches weitestgehend verschnittfrei herstellbar ist und vielfältige Anklemmungsmöglichkeiten für im Gehäuse anzuordnende elektronische oder elektrische Bauteile bietet.

Diese Aufgabe wird erfindungsgemäß dadurch gelöst, daß die den Rahmen bildenden Seitenwände aus an ihren der Vorderwand und der Rückwand zugewandten Längskanten mehrfach abgewinkelten und im Querschnitt etwa C-förmig gestalteten Profilen bestehen, daß die Abkantungen auf beiden Seiten des Rahmens gleich ausgeführt und derart gestaltet sind, daß sich an die aufeinander zulaufenden Stege der etwa C-förmigen Profile jeweils ein parallel zur Vorder- oder Rückwand erstreckender Mittelsteg anschließt, daß sich an jeden Mittelsteg wiederum ein in Richtung der Vorder- oder Rückwand erstreckender Abschlußsteg anschließt und daß dieser Abschlußsteg mit dem jeweils zugeordneten Mittelsteg einen spitzen Winkel einschließt.

Ein derartig gestaltetes Gehäuse bietet eine Vielzahl von Vorteilen.

Bedingt dadurch, daß die Seitenwände einen in sich geschlossenen, separaten Rahmen bilden, entsteht insgesamt praktisch keinerlei Verschnitt bei der Herstellung eines derartigen Gehäuses, da der Verschnitt im Eckbereich, wie er bei kastenförmigen Konstruktionen entsteht, vollkommen vermieden wird.

Durch die mehrfache Abkantung der einerseits der Vorderwand und andererseits der Rückwand zugewandten Längskanten der Seitenwände werden im wesentlichen auf jeder Seite des Rahmens zwei Nuten gebildet, wobei eine der jeweiligen Nuten im späteren Gehäuseinneren und jeweils eine der Nuten im von außen zugänglichen Bereich des Gehäuses liegt. Die im Inneren liegenden Nuten können genutzt werden, um Tragschienen für im Gehäuseinneren zu montierende elektrische oder elektronische Bauteile aufzunehmen. Die der Außenseite zugewandten Nuten können insbesondere dazu benutzt werden, eine Rückwand am Rahmen festzulegen durch innerhalb dieser Nuten verschiebbare Muttern, außerdem können die jeweiligen nach außen weisenden Abschlußstege als Anlage für Dichtringe genutzt werden, die beispielsweise an einer Rückwand oder einer Vorderwand, speziell einer Tür, befestigt sind, so daß das Gehäuse auch problemlos einwandfrei wasserdicht abgschlossen werden kann.

Weitere Merkmale der Erfindung sind Gegenstand weiterer Unteransprüche.

Ausführungsbeispiele der Erfindung sind in den beigefügten Zeichnungen dargestellt und werden im folgenden näher beschrieben.

Es zeigen:
- Figur 1: Eine perspektivische Darstellung eines erfindungsgemäßen Gehäuses mit teilweise aufgebrochen gezeigter Rückwand,
- Figur 2: einen Schnitt nach der Linie II-II in Figur 1,
- Figur 3: einen Schnitt nach der Linie III-III in Figur 1,
- Figur 4: einen Schnitt nach der Linie IV-IV in Figur 1,
- Figur 5: einen Schnitt nach der Linie V-V in Figur 1,
- Figur 6: eine perspektivische Darstellung eines flachliegenden Zuschnittes zur Bildung eines aus vier Seitenwänden bestehenden Rahmens des Gehäuses nach Figur 1,
- Figur 7: eine perspektivische Darstellung des Zuschnittes nach Figur 6 nach mehrfacher Abkantung der Seitenkanten des Zuschnittes.

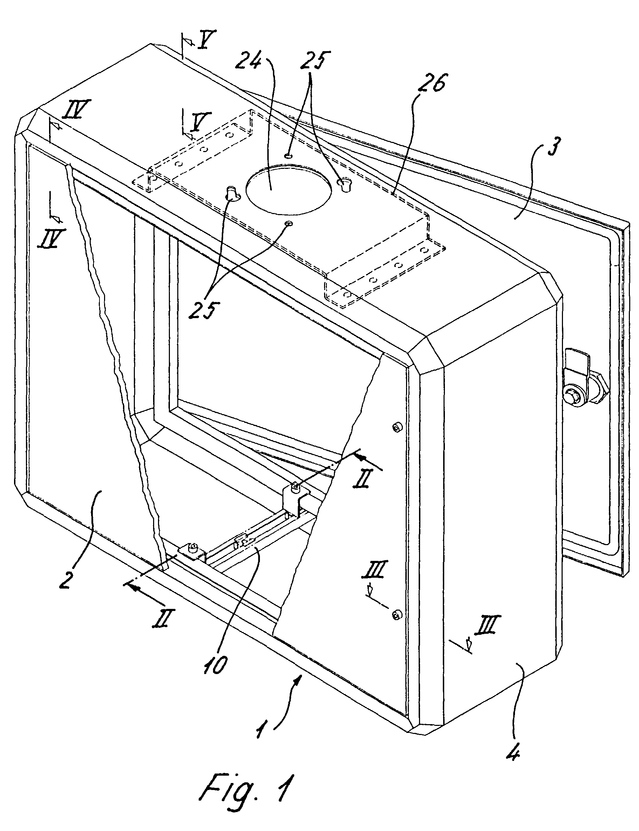

Das in Figur 1 in perspektivischer Darstellung gezeigte, rechteckige Gehäuse 1 zur Aufnahme elektrischer oder elektronischer Bauteile umfaßt im wesentlichen eine aufgebrochen dargestellte Rückwand 2, eine als anscharnierte Tür 3 ausgebildete Vorderwand sowie einen aus vier Seitenwänden bestehenden Rahmen 4.

Zumindest der Rahmen 4 ist aus Blech hergestellt, vorteilhafterweise aber auch die Rückwand 2 und die Tür 3.

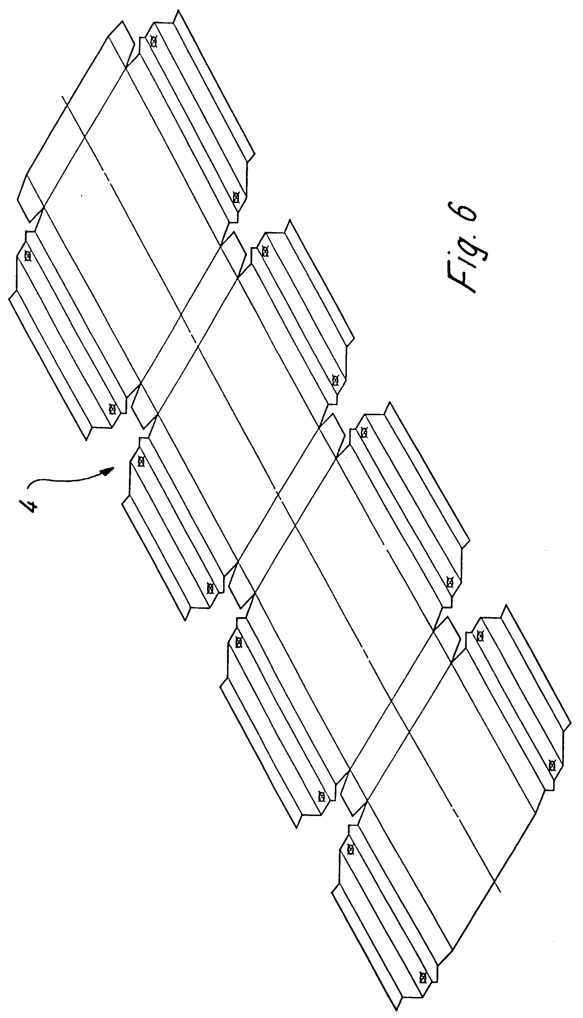

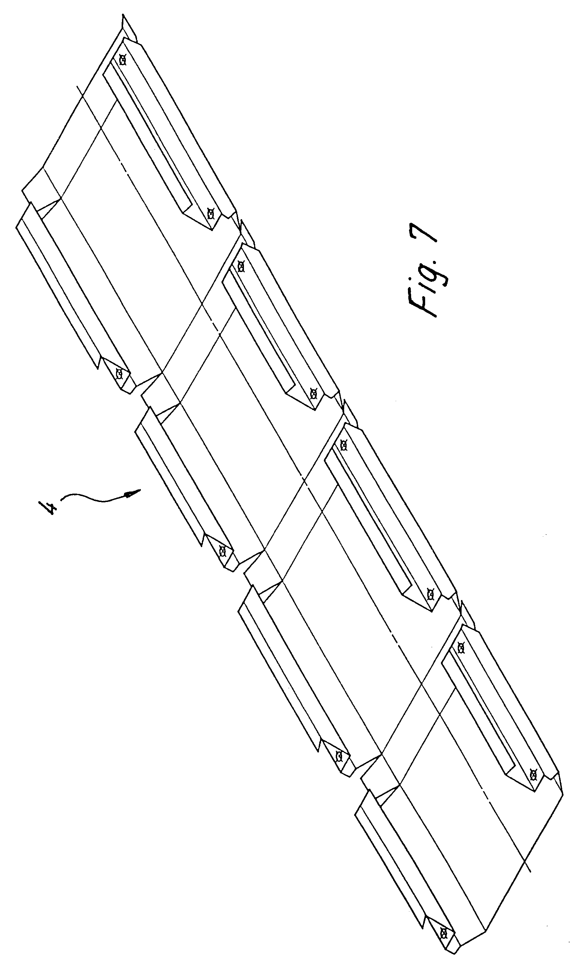

Der die Seitenwände bildende Rahmen 4 ist aus einem einstückigen Zuschnitt gemäß Figur 6 hergestellt, wobei der zunächst flachliegende Zuschnitt im Bereich seiner - nach Fertigstellung des Rahmens 4 der Rückwand 2 und der Tür 3 zugewandten Längskanten - mehrfach abgewinkelt wird, so wie dies dann die Figur 7 zeigt.

Nach dem die Abkantungen der Seitenkanten durchgeführt sind, wird der Zuschnitt zu einem Rahmen zusammengefaltet und dann an einer Ecke verschweißt.

Der Rahmen 4 kann selbstverständlich auch aus einem unterteilten Zuschnitt hergestellt werden, so daß jeweils zwei Seitenwände aus einem einstückigen Zuschnitt gebildet sind. In diesem Falle würde dann an zwei einander gegenüberliegenden Eckbereichen des Rahmens die Verbindung durch Schweißnähte hergestellt werden müssen.

Im Rahmen der vorliegenden Erfindung ist dies von zweitrangiger Bedeutung, entscheidend ist, daß durch die mehrfache Abkantung der Seitenkanten ein Rahmen 4 gebildet werden kann, dessen Seitenwände etwa C-förmig gestaltete Profile aufweisen.

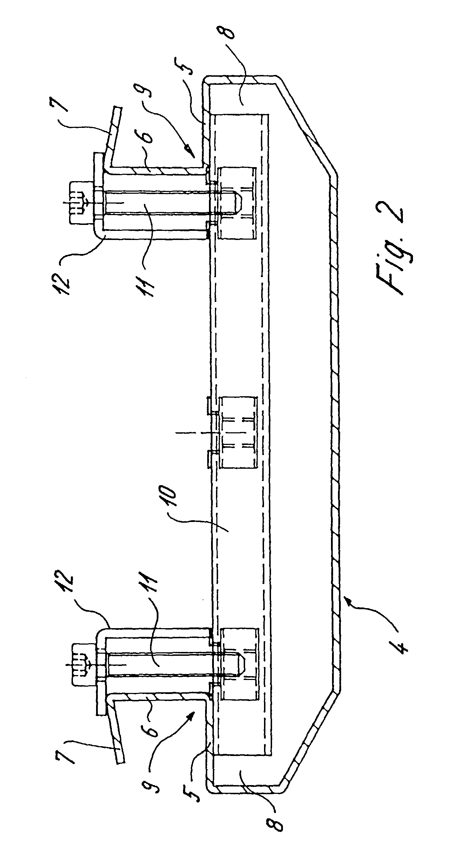

Wie insbesondere aus Figur 2 hervorgeht, sind die Abkantungen auf beiden Seiten des Rahmens 4 gleich ausgeführt und derart gestaltet, daß sich an die aufeinander zulaufenden Stege 5 der etwa C-förmigen Profile jeweils ein parallel zur Vorder- oder Rückwand erstreckender Mittelsteg 6 anschließt, an den sich wiederum jeweils ein Abschlußsteg 7 anschließt, der in Richtung der Vorder- oder Rückwand verläuft und mit dem jeweils zugeordneten Mittelsteg 6 einen spitzen Winkel einschließt.

Durch diese mehrfache Abkantung wird im Inneren des Gehäuses 1 zu beiden Seiten des Rahmens eine hinterschnittene Nut 8 und eine zur Vorder- bzw. Rückwand hin offene, hinterschnittene Aufnahmenut 9 gebildet.

Die im Inneren des Gehäuses 1 liegenden hinterschnittenen Nuten 8 können vorteilhafterweise zur Aufnahme von Montageschienen 10 genutzt werden, an denen elektrische oder elektronische Bauteile in bekannter Weise festgelegt werden können. Diese Montageschienen 10 werden mit ihren stirnseitigen Enden in den Bereich der hinterschnittenen Nuten 8 eingesetzt und über Schrauben 11 an die Stege 5 angezogen, wobei die Schrauben 11 Stützwinkel 12 durchtreten, die einerseits auf den Abschlußstegen 7 und andererseits auf der Montageschiene 10 unmittelbar aufliegen. Es ist also nicht erforderlich, innerhalb des Gehäuses besondere Maßnahmen zu treffen, um Montageschienen 10 zur Aufnahme elektrischer oder elektronischer Bauteile anbringen zu können.

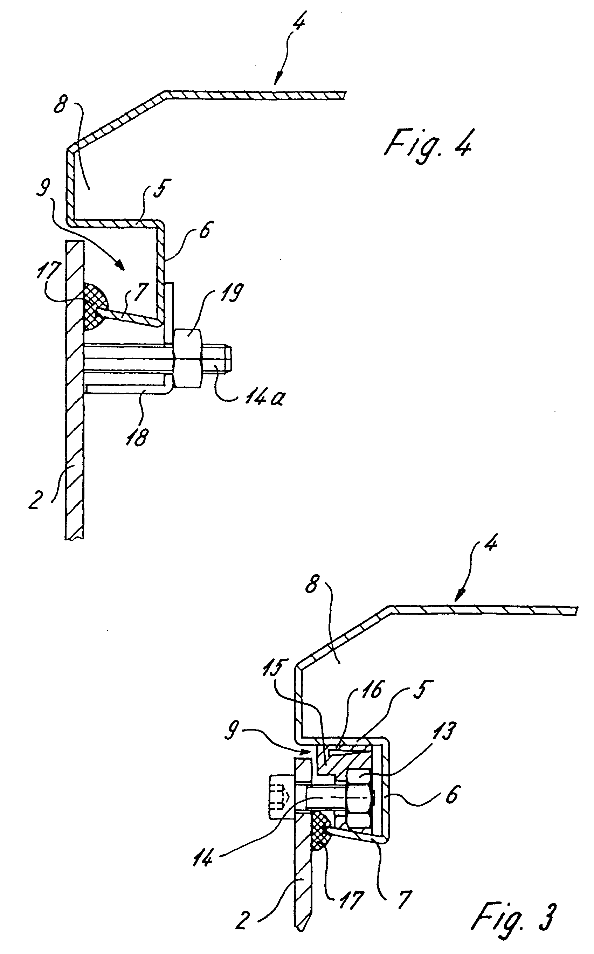

Wie Figur 3 deutlich zeigt, können die außenliegenden Aufnahmenuten 9 dazu genutzt werden, verschiebbare Muttern 13 aufzunehmen, in die Befestigungsschrauben 14 eingeschraubt sind, um beispielsweise die Rückwand 2 am Gehäuse bzw. am Rahmen 4 des Gehäuses festzulegen. Vorteilhafterweise sind die Muttern 13 in aus Kunststoff gefertigte Formteile 15 eingesetzt, die mit einem federnden Flansch 16 ausgestattet sind. Diese Formteile 15 sind im Querschnitt der Aufnahmenuten 9 angepaßt und können aufgrund ihres federnden Flansches 16 unter einem gewissen Reibschluß sicher innerhalb der Aufnahmenut 9 positioniert werden.

Wie Figur 3 weiterhin zeigt, kann auf der dem Gehäuseinneren zugewandten Seite der Rückwand 2 eine umlaufende Dichtung 17 befestigt sein, die sich auf dem Abschlußsteg 7 abstützt. Hierdurch wird auf einfache Art und Weise ein einwandfrei dichter Abschluß der Rückwand 2 gegenüber dem Rahmen 4 des Gehäuses erzielt.

Figur 4 macht andeutungsweise deutlich, daß eine Festlegung der Rückwand 2 auch durch im Gehäuseinneren liegende Befestigungsschrauben 14a möglich ist. Diese Befestigungsschrauben 14a sind in diesem Falle an der Rückwand 2 als Schraubbolzen befestigt und auf dem jeweiligen Mittelsteg 6 stützt sich ein Befestigungswinkel 18 ab, der mit seinem anderen Schenkel unmittelbar auf der Rückwand 2 aufliegt. Durch eine entsprechende Mutter 19, die auf den Schraubbolzen 14a aufgeschraubt wird, ist eine feste Verbindung der Rückwand 2 mit dem Rahmen 4 möglich. Auch hier ist die Rückwand 2 mit einer umlaufenden Dichtung 17 ausgestattet, die sich auf dem Abschlußsteg 7 abstützt.

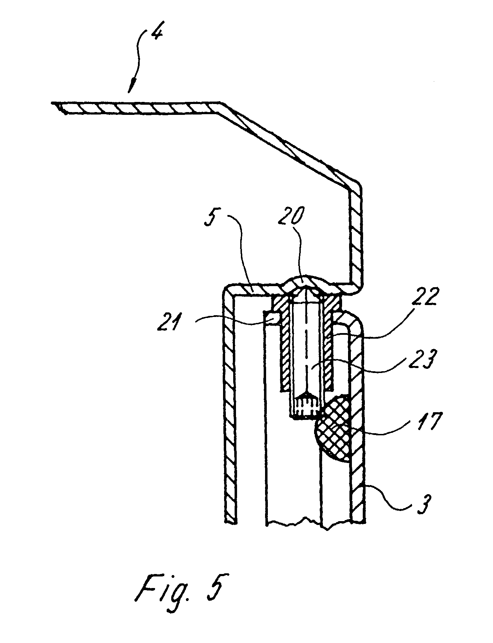

Die Figur 5 zeigt eine vorteilhafte Scharnierkonstruktion für die Tür 3 des Gehäuses 1. Figur 5 macht deutlich, daß die aufeinander zulaufenden Stege 5 der etwa C-förmig gestalteten Profile 4 Sicken 20 eingeprägt sind.

In einen Randsteg 21 der Tür 3 sind Gewindehülsen 22 eingeschweißt, in die jeweils ein Gewindestift 23 eingeschraubt ist. Die Spitze des jeweiligen Gewindestiftes 23 wird in die eingeprägte Sicke 20 des jeweiligen Steges 5 eingesetzt und bildet praktisch eine Scharnierachse für die Tür 3. Da die Konstruktion des Rahmens 4 durch die eingeprägte Sicke nicht durchbrochen ist, wird auch eine einwandfrei dichte Anbringung der Tür 3 möglich, wobei dies unterstützt wird durch eine umlaufende und mit der Tür 3 verbundene Dichtung 17, die sich analog der Rückwand 2 an den in Figur 5 nicht erkennbaren Abschlußstegen des Rahmens 4 abstützt.

Wie Figur 1 deutlich macht, ist eine der Seitenwände des Gehäuses 1 mit einer Durchbrechung 24 sowie mit mehreren, konzentrisch zu dieser Durchbrechung 24 auf einem Kreisbogen angeordneten Durchgangslöchern 25 versehen. Dabei weisen mindestens zwei dieser Durchgangslöcher eine Schlüssellochform auf. Im Bereich des Durchbruches 24 sowie der Durchgangslöcher 25 ist die betreffende Seitenwand mit einer im Gehäuseinneren liegenden Versteifungsplatte 26 versehen.

Gehäuse der hier in Rede stehenden Art werden üblicherweise an entsprechenden Tragvorrichtungen montiert. Durch die Durchgangslöcher 25 werden dann entsprechende Schrauben hindurchgeführt, um das Gehäuse an einer Trageinrichtung festlegen zu können. Bedingt dadurch, daß zumindest zwei dieser Durchgangslöcher 25 eine Schlüssellochform aufweisen, können zwei Befestigungsschrauben schon an einer Trageinrichtung in einer Vormontagestellung eingeschraubt sein, anschließend wird das Gehäuse schon an diesen Schrauben provisorisch aufgehängt, so daß anschließend auch noch die übrigen Befestigungsschrauben angesetzt und dann endgültig festgeschraubt werden können. Die gesamte Montage kann auf einfache Art und Weise von nur einer Person ausgeführt werden, da das Gehäuse 1 problemlos in eine Vormontagestellung gebracht werden kann.

In Abweichung vom dargestellten Ausführungsbeispiel ist es natürlich auch denkbar, das Gehäuse 1 beidseitig mit anscharnierten Türen 3 oder beidseitig mit festverschraubten Vorder- und Rückwänden zu versehen.

## Patentansprüche

1. Rechteckiges Gehäuse zur Aufnahme von elektrischen oder elektronischen Bauteilen, umfassend eine Rückwand und eine vorzugsweise als anscharnierte Tür ausgebildete Vorderwand, sowie einen aus vier Seitenwänden bestehenden Rahmen, mit dem die Rückwand und die Vorderwand verbunden sind, wobei zumindest der Rahmen aus Blech hergestellt ist, **dadurch gekennzeichnet, daß** die den Rahmen (4) bildenden Seitenwände aus an ihren der Vorderwand (3) und der Rückwand (2) zugewandten Längskanten mehrfach abgewinkelten und im Querschnitt etwa C-förmig gestalteten Profilen bestehen, daß die Abkantungen aufbeiden Seiten des Rahmens (4) gleich ausgeführt und derart gestaltet sind, daß sich an die aufeinander zulaufenden Stege (5) der etwa C-förmigen Profile jeweils ein parallel zur Vorder- oder Rückwand (3, 2) erstreckender Mittelsteg (6) anschließt, daß sich anjeden Mittelsteg (6) wiederum ein in Richtung der Vorder- oder Rückwand (3,2) erstreckender Abschlußsteg (7) anschließt und daß dieser Abschlußsteg (7) mit dem jeweils zugeordneten Mittelsteg (6) einen spitzen Winkel einschließt.

2. Gehäuse nach Anspruch 1, **dadurch gekennzeichnet, daß** eine der Seitenwände mit mehreren, auf einem gemeinsamen Teil greifliegenden Durchgangslöchern (25) versehen ist, von denen mindestens zwei eine Schlüssellochform aufweisen.

3. Gehäuse nach Anspruch 2, **dadurch gekennzeichnet, daß** die Durchgangslöcher (25) konzentrisch zu einer Durchbrechung (24) der Seitenwand angeordnet sind.

4. Gehäuse nach Anspruch 2 oder 3, **dadurch gekennzeichnet, daß** die mit der Durchbrechung (24) und den Durchgangslöchern (25) versehene Seitenwand mit einer innerhalb des Gehäuses einfliegenden Verstärkungsplatte (26) versehen ist.

5. Gehäuse nach einem oder mehreren der vorhergehenden Ansprüche, **dadurch gekennzeichnet, daß** durch die aufeinander zulaufenden Stege (5) der etwa C-förmigen Profile, durch die Mittelstege (6) und die Abschlußstege (7) eine zur Vorder- oder Rückwand (3,2) hin offene, hinterschnittene Aufnahmenut (9) für längs dieser Aufnahmenut (9) verschiebbare Muttern (13) gebildet ist.

6. Gehäuse nach Anspruch 5, **dadurch gekennzeichnet, daß** die Muttern (13) in aus Kunststoff gefertigte Formteile (15) mit einem federnden Flansch (16) eingesetzt sind, wobei die Formteile (15) dem Querschnitt der Aufnahmenuten (9) angepaßt und aufgrund des federnden Flansches (16) reibschlüssig in den Aufnahmenuten (9) verschoben werden können.

7. Gehäuse nach einem oder mehreren der vorhergehenden Ansprüche, **dadurch gekennzeichnet, daß** an der Rückwand (2) in Richtung des Gehäuseinneren verlaufende Gewindebolzen (14a) befestigt sind, welche jeweils einen Scherkel eines Stützwinkels (18) durchtreten, der sich auf einem Mittelsteg des Rahmens abstützt und gegen den eine auf den jeweiligen Gewindebolzen (14a) aufgeschraubte Mutter (19) angezogen ist, die den anderen Schenkel des Stützwinkels (18) gegen die Innenseite der Rückwand (2) andrückt.

8. Gehäuse nach einem oder mehreren der vorhergehenden Ansprüche, **dadurch gekennzeichnet, daß** an der Innenseite der Rückwand (2) eine umlaufende Dichtung (17) befestigt ist, die an die freien Kanten der Abschlußstege (7) angepreßt ist.

9. Gehäuse nach einem oder mehreren der vorhergehenden Ansprüche, **dadurch** g**ekennzeichnet, daß** die C-förmig abgekanteten Seitenwände des Rahmens (4) im Gehäuseinneren hinterschnittene Nuten (8) aufweisen, die zur Aufnahme von Montageschienen (10) für die Befestigung elektrischer oder elektronischer Bauteile dienen.

10. Gehäuse nach Anspruch 9, **dadurch gekennzeichnet, daß** die Montageschienen (10) über Schrauben (11) und Stützwinkel (12) gegen die aufeinander zulaufenden Stege (5) der etwa C-förmigen Profile angezogen sind.

11. Gehäuse nach einem oder mehreren der vorhergehenden Ansprüche, **dadurch gekennzeichnet, daß** in die aufeinander zulaufenden Stege (5) der etwa C-förmigen Profile im Eckbereich des Rahmens (4) Sicken (20) eingeprägt die als Lager für Scharnierachsen einer Tür (3) dienen.

12. Gehäuse nach Anspruch 11, **dadurch gekennzeichnet, daß** die Scharnierachsen aus Gewindebolzen (23) bestehen, die in Gewindehülsen (22) eingeschraubt sind, wobei die Gewindehülsen (22) fest mit der Tür (3) verbunden sind.
